Europäisches Patentamt

European Patent Office

Office européen des brevets

(19)

(11) **EP 1 633 045 A1**

(12) **EUROPEAN PATENT APPLICATION**

(43) Date of publication:
08.03.2006 Bulletin 2006/10

(51) Int Cl.:
*H03K 7/08* (2006.01)    *H03K 9/08* (2006.01)
*H03K 5/26* (2006.01)

(21) Application number: 04255320.6

(22) Date of filing: 02.09.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(71) Applicant: SIEMENS AKTIENGESELLSCHAFT
80333 München (DE)

(72) Inventors:
• **Kenney, Richard**
CW1 5TY, Haslington (GB)

• **Thompson, Kenneth**
**SK11 7BZ**
**Macclesfield (GB)**

(74) Representative: **Morgan, Marc et al**
**Siemens AG,**
**Postfach 22 16 34**
**80506 Munich (DE)**

(54) **An electrical circuit**

(57) A circuit is used to provide the fundamental frequency of two input PWM signals of different phases by use of a Set Reset Latch circuit.

Figure 2.

## Description

This invention relates to an electrical circuit for use in a drive system involving inverters.

In drive systems, it is necessary to provide an independent feedback signal from the output of an inverter to a monitoring control system. This monitoring loop allows the inverter output to be disabled if the main control system goes wrong.

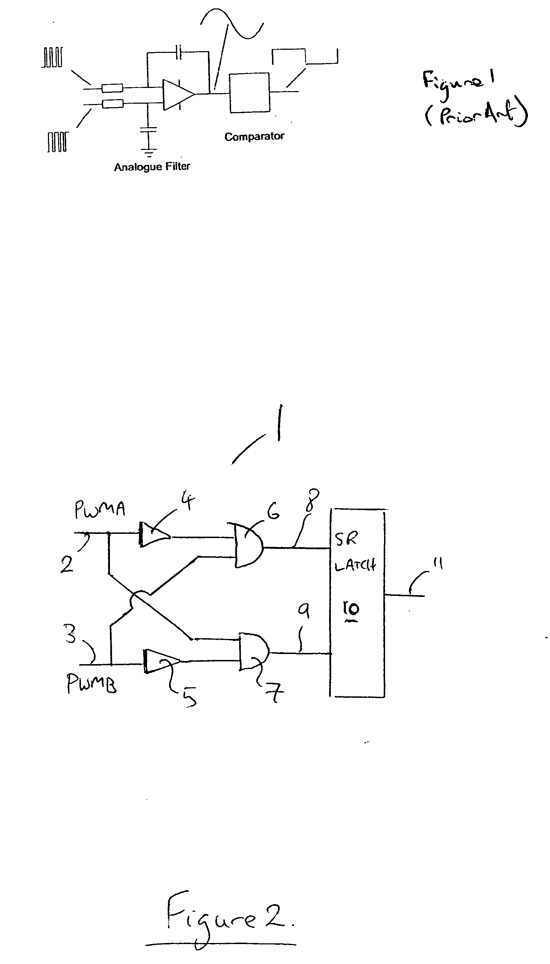

Normally, the feedback signal is derived from the output of the inverter by a circuit using analogue filtering of the pulse width modulated signal output by the inverter in two phases. In this way, the switching frequency is eliminated and the fundamental output voltage frequency derived. The resultant analogue signal containing only the fundamental frequency is then typically converted to a digital signal by use of a comparator. An example of such a circuit is shown in prior art figure 1.

A problem with existing circuits is that they have to eliminate a large high frequency signal and to accurately amplify a low frequency signal which has a relatively low amplitude. (For example, a 5Hz, 5V fundamental frequency may be present on a 750V PWM signal which is a ratio of greater than 150:1). As a consequence very high quality components are required.

According to the invention there is provided a circuit for providing a signal representative of a fundamental frequency of input PWM signals a first input and a second input to, in use, be coupled to a source of PWM signals, means coupled to the inputs to produce a Boolean NOT of the signals, means to produce a Boolean AND of a signal with the Boolean NOT of another to produce a first Boolean output and means to Boolean AND the other signal with the other Boolean NOT to produce a second Boolean output, a set reset latch circuit coupled to the first and the second Boolean outputs and responsive thereto to provide a square wave output at the fundamental frequency of the input PWM signals.

A specific embodiment of the invention will now be described with reference to the drawing in which:-

Figure 1 is a prior art circuit;
Figure 2 shows in block diagram form a first embodiment of the invention;
Figure 3 is an explanatory diagram showing various outputs and input signals involved in the apparatus of figure 2;
Figure 4 shows a first practical circuit in accordance with the invention; and
Figure 5 is a second embodiment of the invention.

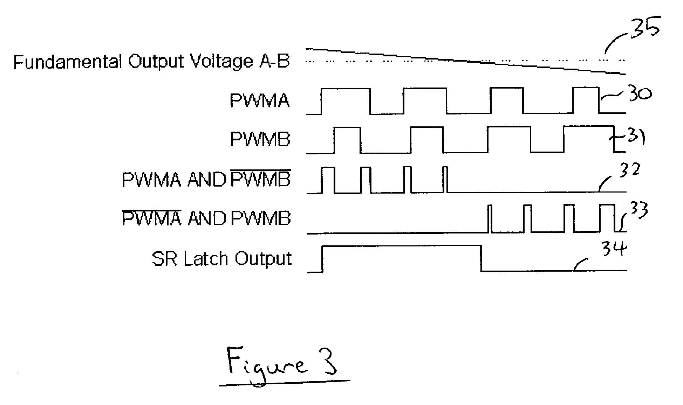

As is shown in figure 2, an electrical circuit 1 in accordance with the invention comprises a first input 2, a second input 3 coupled to an inverter (not shown) producing Pulse Width Modulated (PWM) signals PWMA and PWMB. The inputs are connected to a section 4, 5 providing a Boolean NOT operation. Thus the sections 4, 5 output $\overline{\text{PWMA}}$ and $\overline{\text{PWMB}}$ which are coupled to respective Boolean AND sections 6 and 7. The other input of the sections 6 and 7 are coupled to the signal inputs 2,3. Thus, section 6 is connected to input 3 and section 7 is coupled to input 2.

Accordingly section 6 has inputs $\overline{\text{PWMA}}$ and PWMB and produces the output 8 being PWMA AND $\overline{\text{PWMB}}$. Section 7 has inputs $\overline{\text{PWMB}}$ and PWMA to produce an output 9 $\overline{\text{PWMB}}$ AND PWMA.

The outputs 8 and 9 are coupled to a Set Reset Latch 10 which produces an output 11 which is the required fundamental frequency of the applied PWM signal.

Figure 3 shows the signals applied to and derived by the circuit 1. Signal 30 is the waveform PWMA applied to input 2 and signal 31 is the waveform PWMB applied to input 3. It will be seen that the more positive phase PWMA goes high first and low last. As a result, the logic signal PWMA AND $\overline{\text{PWMB}}$ waveform 32 will be low when PWMA is on average more negative than PWMB. When PWMA is more positive, then a train of pulses is produced, the mark space ratio of which is proportional to the average voltage difference between the two phases. A similar signal is derived for $\overline{\text{PWMA}}$ AND PWMB as shown in waveform 33.

When the waveform 32 goes high, the latch output 34 goes high (the waveform 32 being input to the latch as described). This state is maintained until waveform 33 goes high on the reset input to the latch. Then the latch output goes low as shown in waveform 34.

It will be seen that the waveform 34 is a square waveform matching the fundamental output voltage A-B shown in waveform 35.

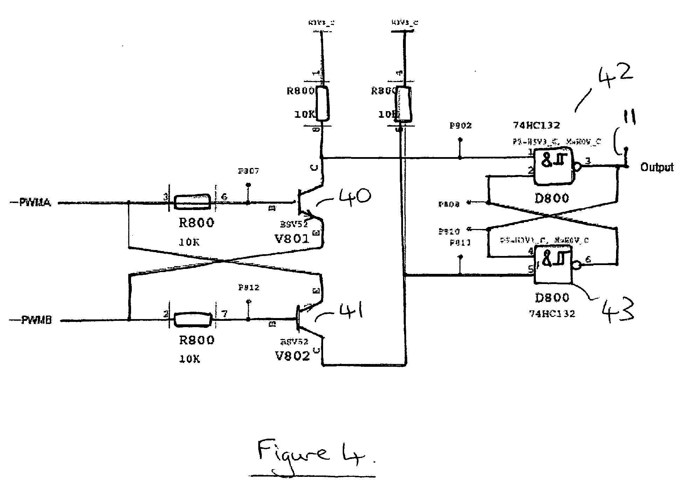

The practical circuit shown in figure 4 uses two transistors 40, 41 to act as two AND gates and inverters. These provide the waveforms 32 and 32 to the set reset latch provided by two AND gates 42 and 43. The resistors are required to correctly bias the transistors.

The output is labelled 11 as in the figure 3.

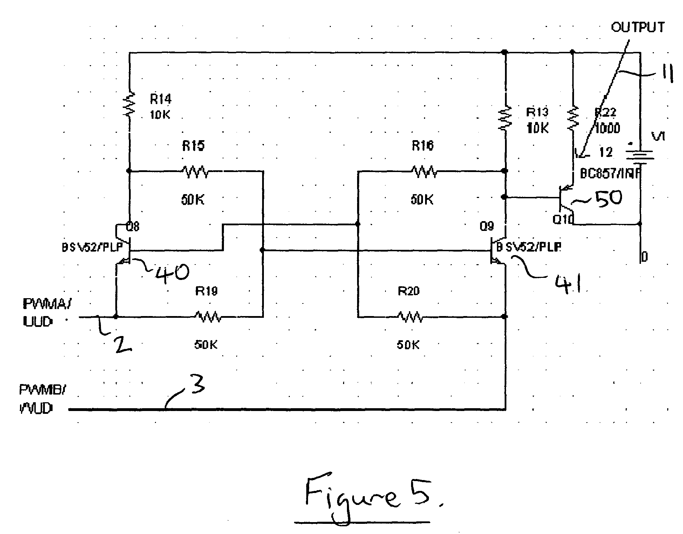

Figure 5 shows an alternative embodiment using two transistors 40 and 41 to provide the logical gates, inverter and latch. A further transistor 50 to provides buffering for the output 11.

## Claims

1. A circuit for providing a signal representative of fundamental frequency of input Pulse Width Modulated Signals comprising a first input and a second input to, in use, be coupled to a source of PWM signals, means coupled to the inputs to produce a Boolean NOT of the signals, means to Boolean AND a signal with the Boolean NOT of another to produce a first Boolean output and means to Boolean AND the other signal with the other Boolean NOT to produce a second Boolean output, a set reset latch circuit coupled to the first and the second Boolean outputs and responsive thereto to provide a square wave output at the fundamental frequency of the input PWM signals.

Figure 1
(Prior Art)

Comparator

Analogue Filter

Figure 2.

Figure 3

Figure 4.

Figure 5.

European Patent
Office

**EUROPEAN SEARCH REPORT**

Application Number

EP 04 25 5320

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 3 313 927 A (RAIKE RONALD R ET AL) 11 April 1967 (1967-04-11) * the whole document * | 1 | H03K7/08 H03K9/08 H03K5/26 |
| A | EP 0 730 341 A (SONY CORPORATION) 4 September 1996 (1996-09-04) * figure 8 * | 1 | |
| A | FR 2 432 798 A (ACCUMULATEURS FIXES ET TRACTION) 29 February 1980 (1980-02-29) * the whole document * | 1 | |
| A | US 5 440 229 A (SCHIEMAN ET AL) 8 August 1995 (1995-08-08) * the whole document * | 1 | |

TECHNICAL FIELDS
SEARCHED (Int.Cl.7)

H03K
H02M
G01R

The present search report has been drawn up for all claims

| Place of search | Date of completion of the search | Examiner |
|---|---|---|
| The Hague | 10 February 2005 | Jepsen, J |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

......................................................................................................

& : member of the same patent family, corresponding
      document

EPO FORM 1503 03.82 (P04C01)

## ANNEX TO THE EUROPEAN SEARCH REPORT
## ON EUROPEAN PATENT APPLICATION NO.

EP 04 25 5320

This annex lists the patent family members relating to the patent documents cited in  the above-mentioned European search report.
The members are as contained in the European Patent Office EDP file on
The European Patent Office is in no way  liable for these particulars which are merely  given for the purpose of information.

10-02-2005

| Patent document cited in search report | | Publication date | Patent family member(s) | | Publication date |
|---|---|---|---|---|---|
| US 3313927 | A | 11-04-1967 | FR | 1410883 A | 10-09-1965 |
| EP 0730341 | A | 04-09-1996 | JP | 8223970 A | 30-08-1996 |
| | | | JP | 8223975 A | 30-08-1996 |
| | | | JP | 8223976 A | 30-08-1996 |
| | | | CN | 1145548 A ,C | 19-03-1997 |
| | | | EP | 0730341 A2 | 04-09-1996 |
| | | | SG | 42337 A1 | 15-08-1997 |
| | | | US | 5869944 A | 09-02-1999 |
| FR 2432798 | A | 29-02-1980 | FR | 2432798 A1 | 29-02-1980 |
| US 5440229 | A | 08-08-1995 | NONE | | |

EPO FORM P0459

For more details about this annex : see Official Journal of the European Patent Office, No. 12/82